# EUROPEAN PATENT APPLICATION

(11) **EP 4 447 325 A1**
(43) Date of publication of application: **16.10.2024**
(21) Application number: 23167919.2
(22) Date of filing: 14.04.2023
(51) Int. Cl.: H03M 1/68, H03M 1/80

(54) **DIGITAL TO ANALOG CONVERTER AND AUDIO AMPLIFIER ASSOCIATED**

(71) Applicant: Naim Audio Limited, Salisbury Wiltshire SP1 2LN (GB)
(72) Inventor: SPENCER SELLS, Steven Guy, Downton (Wiltshire), SP5 3PW (GB); O'BRIAN, Dean, Awbridge, Romsey (Hampshire), SO51 0HL (GB)
(74) Representative: Cabinet Laurent & Charras

(57) **Abstract**

The invention concerns a digital to analog converter (20) comprising :
- a digital input (Di) that can take multiple logical levels;
- a resistive network (21a); and
- an analog output (Vout) connected to said resistive network (21a) in order to produce an output voltage variable as a function of said logical levels of said digital input;
- at least two thermometer clusters (22a, 22b) implemented in said resistive network (21a) with different weights on the analog output (Vout); for each thermometer cluster (22a, 22b), only one switch (23) is moved in each incrementation or diminution of the logic level of the thermometer cluster (22a, 22b); and
- a logical command unit (24) configured to convert said digital input (Di) into binary words (Bw1, Bw2) in order to associate a dedicated binary word to each thermometer cluster (22a, 22b).

## Description

### TECHNICAL FIELD

The invention relates to a digital to analog converter of electric signals and an audio amplifier associated.

More precisely, the invention relates to a digital to analog converter designed specifically for music reproduction by audio devices such as headsets or amplifiers.

The purpose of the invention is to provide a digital to analog converter with low noise, low glitch energy, practical part count, scalable and capable of high-resolution audio such as 768 kHz 32-bit streams.

### BACKGROUND

A digital to analog converter (DAC) is a device where a number is input and an analogue output proportional to the size of the number is output.

DACs are not new; their roots can be considered to go back 4000 years to Egyptian weighing scales. The input had multiple discrete weights (digital) that could be added or subtracted to balance a dial (analogue). The next evolution was from Lord Kelvin in the mid 1800's better known for his works on thermodynamics and the Kelvin scale. The DAC was a string DAC implemented with a string of resistors and relays, in essence like a discrete step mechanical potentiometer. This was enhanced by cascading floating string DACs to achieve an astonishing 0.1 ppm resolution. It was called the Kelvin-Varley divider.

The first DAC patent US 1,514,753 was filed in 1920 by Peter I. Wold for his "signal receiving system". It was a thermometer DAC made with resistors, relays and tubes. A second DAC US 1,608,527 was patented by Paul Rainey for a "Facsimile Telegraph System" in 1921 using pulse code modulation (PCM). The first audio DACs were developed in the late 1940's in complete secrecy. These were for military voice encryption and used pulse code modulation (PCM). The system was called "SYGSALY". It took until the 1960's and 70's for DACs to mature to how we'd recognize them today.

Since the introduction of CD players in October 1982 the use of audio DACs have become increasingly more significant in the world of high-performance audio. Their performance has dramatically improved over the intervening 40 years. In the 1980's DACs were expensive, and many CD players had one DAC. The DAC would swap between left and right channels every sample, consequently leaving an 11 µs inter-channel delay. Today DACs are plentiful and can be so small as to be hidden in a headphone connector. At the other end of the scale, audio DACs can give incredible musical performance.

All early audio DACs were "multi-level" (AKA `multi-bit', `PCM', `first Nyquist band', `R2R' or `ladder') technology. These early DACs suffered from a multitude of technical limitations. They would run slow, take lots of power, create lots of "in" and "out" of band noise and had high distortion. Over the years, they were refined to give excellent performance but remained expensive. Some of these DACs still have a cult following today for their natural timbre of sound.

Multi-level DACs being expensive meant the race was on to develop affordable DACs to enable CD for the masses. In 1988 Philips introduced their first 1-bit DAC (AKA "oversampling", "Bitstream" or "Delta-Sigma" DACs). These DACs used an entirely different architecture and took advantage of signal processing. This technology is significantly easier to manufacture and so more affordable. Today, all audio DACs use this technology with only a few exceptions. There are a few high-end audio manufactures using either "new old stock" multi-level DAC chips or discrete DACs fanatically engineered from shift registers and carefully matched resistors. Great debate goes on to why these esoteric DACs anecdotally sound more musically engaging than Delta-Sigma DACs.

The widely used "Delta-Sigma DACs" have many names: Sigma-delta, DSD, Oversampling DAC, Bitstream, FPGA DACs, Multi-level delta-sigma ...

Delta-Sigma DACs are the most common audio DACs in existence today and represent over 99.9% of all audio DACs. They dominate the industry because they offer great performance, easy to manufacture repeatably and can be dramatically cost engineered.

Delta-Sigma DACs have a very simple actual DAC section but a more complex digital filter section. Delta-Sigma's rise in popularity can be explained by cheaper and cheaper processing power and no need for laser trimming.

Delta-Sigma works by having high sample rates and low bit depths. Information in the audio stream should be considered as a "volume of information". It can be narrow and wide or wide and narrow. This is a very simplistic view and ignores many other parameters but does demonstrate how a 1-bit system can sound like a multibit system. There is a limit to the above simplification. If the maximum frequency to be reproduced is 22.05kHz then the sample rate must be at least two times this; 44. 1kHz in this example.

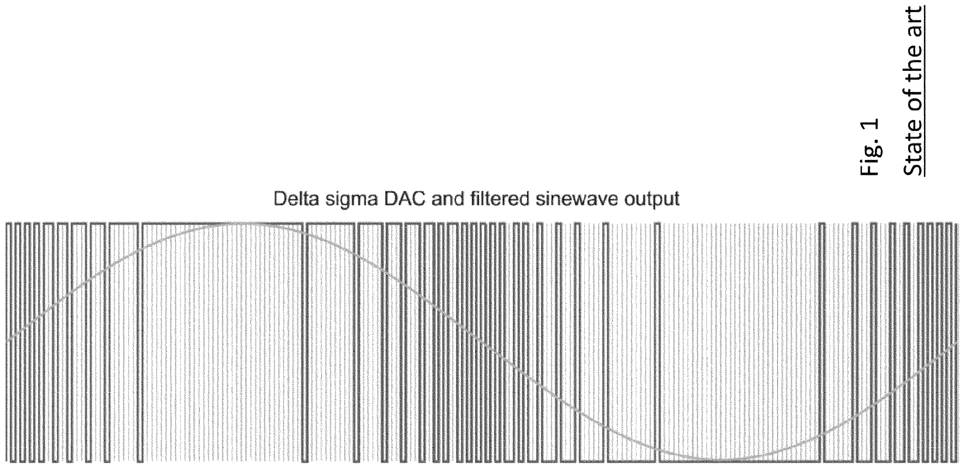

The Figure 1 shows the output from a simple Delta-Sigma DAC (dark line), the resultant sine wave and the sample period (clear line).

The output from the Delta-Sigma DAC has two states (one bit); high and low. If the output was to change equally spending time high and low then the average output would be half. When the sinewave is rising the DAC output steadily spends more time high. Conversely, when the sinewave is going low the DAC output spends more time low. The very high switching rate is then filtered away using an analogue filter leaving just the sinewave.

By adding more levels to Delta-Sigma DACs the resolution for a given sample rate can be improved. The extra levels also reduce the level of filtering needed. For example, if 2 Delta-Sigma DACs are combined there can be a possible 3 levels of output. If 4 Delta-Sigma DACs are combined, then 5 levels can be achieved.

The accuracy of Delta-Sigma DACs relies on the accuracy of the clock. This is because it all works by averaging time spent high and time spent low. An extreme example is where a DAC is used as a voltage reference for an ultra-low noise DC power supply. If the output was to be set to 50% then the delta-sigma DAC would need to continuously switch with a 50:50 mark-space ratio.

Thus, Delta-Sigma DACs are sensitive to clock jitter and can make a RF noise that can depreciate the quality of the sound.

To overcome these issues, a "Nyquist" DAC can be used. Harry Nyquist set the foundations of sampling theory in the 1920's; "Certain Factors Affecting Telegraph Speed," Bell System Technical Journal, Vol. 3, April 1924, pp. 324-346 and "Certain Topics in Telegraph Transmission Theory", A.I.E.E. Transactions, Vol. 47, April 1928, pp. 617-644. His rule was that the sampling frequency must be at least twice the highest frequency contained in the signal or information about the signal will be lost. CD runs at 44.1 kHz and so theoretically can capture up to 22.05kHz.

In this patent, the term "Nyquist DAC" is used as collective for all DACs that run at the sampling frequency when Delta-Sigma DAC is used for all DACs that run significantly higher rates than the sampling frequency. Thus, a Nyquist DACs are more tolerant to clock jitter than Delta-Sigma DAC. Moreover, a Nyquist DAC could set it's MSB on and all other bits off and then freeze. A frozen DAC generates no addition noise than that inherent in components.

A known DAC is the R2R DAC, called "R2R" because of the pattern of resistor values used. R2R DAC is a "Nyquist" DAC.

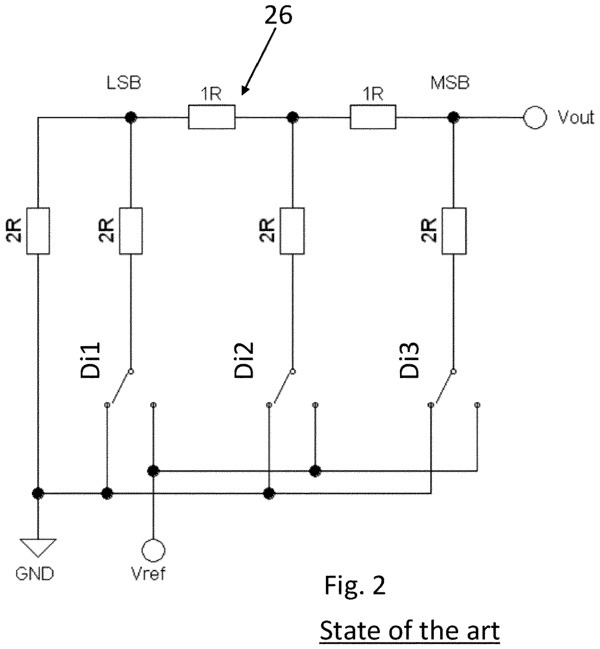

The figure 2 illustrates a 3-bit R2R DAC where the value of the vertical resistors are twice the value of the connection resistors **26**. Its operation is analogous to the Egyptian weighting scales mentioned previously.

When all switches are connected to the ground **GND**, i.e. when all the bits **Di1-Di3** of the digital input are zero, the output **Vout** is zero. To ramp the output **Vout, Di1** can be connected to **Vref**. Then, in a binary fashion, all the switches **Di1-Di3** can be commuted until all switches **Di1-Di3** are connected to **Vref** and the output **Vout** is at full.

In the example of figure 1 above with 3 switches **Di1, Di2** and **Di3** it gives a total possible 8 levels (1 = switch connected to **Vref** and 0 = connected to the ground **GND**):
- Level 1 = 0 0 0 = minimum output;
- Level 2 = 10 0 = 1/7th output;
- Level 3 = 0 1 0 = 2/7th output;
- Level 4 = 1 10 = 3/7th output;
- Level 5 = 0 0 1 = 4/7th output;
- Level 6 = 10 1 = 5/7th output;
- Level 7 = 0 1 1 = 6/7th output; and
- Level 8 = 1 1 1 = max output.

The advantage of an R2R DAC is its efficiency of parts. A 24-bit DAC needs 24 switches and the partnering resistors.

However, the R2R DAC suffers from glitches and can have monotonicity problems. Moreover, errors can be huge and for high resolution incredible accuracy in all parts is needed.

Glitches can occur for many reasons such as bit changeover timing errors, charge injection and cross talk from digital to analogue.

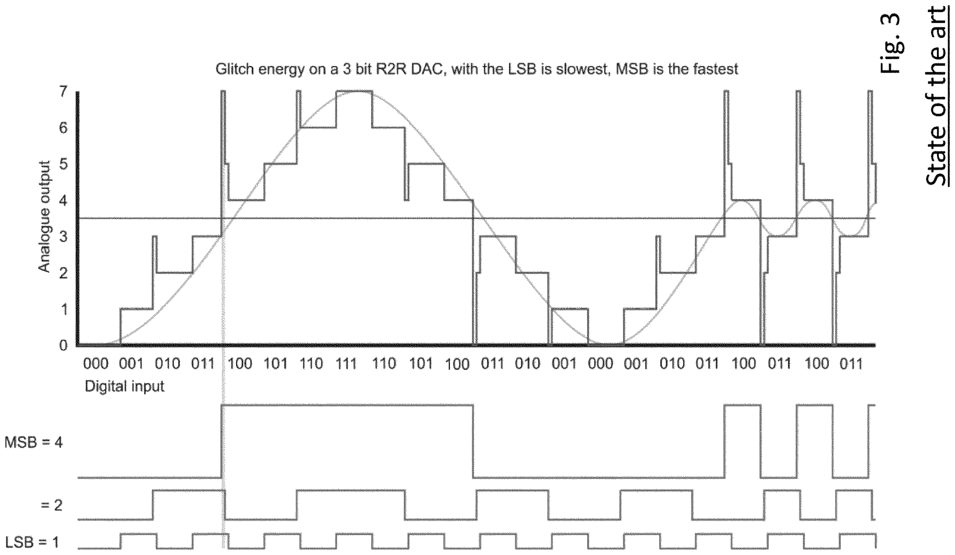

The figure 3 illustrates how glitches occur due to bit timing errors in a 3-bit R2R DAC. The sine wave shows the required audio signal. As the signal level increases positive going glitches occur. As the signal decreases negative going glitches occur the largest glitches occurs as the signal crosses the mid-point. The midpoint for audio is the zero line, hence zero crossing glitch. It can also be seen the size of the zero cross glitch is full amplitude even for the smaller signals. This can be heard as a rising noise floor. The bottom traces show the timing for the 3-bits. Ideally all 3-bits transition at precisely the same time. In practice, there are small timing errors. In figure 3, the MSB transitions occur first and the LSB transitions occur last. The vertical line shows how the 3-bits momentarily combine to cause the glitch.

As the signal passes back and forth through the center line the binary bit pattern counts up and down. For example, if the audio signal is one step below the center line the binary code is 1 1 0 (as per the 3 bit R2R DAC example above). The next step is just above the center line and is 0 0 1. Here all three bits have changed. If we look carefully at the bit pattern, during the nanosecond the bits change, a different picture is depicted. If say the two lower bits change fractionally before the MSB, the bit pattern goes from 1 1 0 to 0 0 0 and then the MSB changes and we have 0 0 1. The 0 0 0 only occurs for a few nanoseconds but does give a full amplitude negative glitch. If the MSB was to be a fraction faster than the lower bits, the bit pattern during change would be 1 1 1. This gives a full amplitude positive glitch.

Glitches from bit timing errors almost render R2R DACs unusable for audio. Initially, the solution was to add a big filter on the output. This didn't cure the problem but smeared the problem. This solution was fine for some applications such as motor control.

Early audio R2R DACs used sample and hold. Sample and hold adds a circuit after the DAC that disconnects the DAC during bit changes. The output level is held with a small capacitor. Once the bit pattern has changed and the glitch has gone the output reconnects.

This circuit would introduce its own problems such as noise and distortion. The most successful solution for removing the biggest glitch (the zero-crossing glitch) is called "sign-magnitude".

The sign-magnitude method uses two DACs to eliminate the MSB glitch. One DAC takes care of the positive signals and the other negative signals. The two DACs are then summed together. Here as the signal moves say upwards away from the center line the positive DAC starts to count up using the LSB bits. This way the MSB is not changed and as such does not cause a zero-crossing glitch.

The disadvantage of sign-magnitude DACs is that they only eliminate the MSB glitch. It does not eliminate the glitch of the next most significant bit down and the bit after that etc. Sign-magnitude nearly doubles the DAC component count. To make a 24-bit sign-magnitude DAC two 23-bit DACs are needed or a method of changing the reference voltage or current from positive to negative as required.

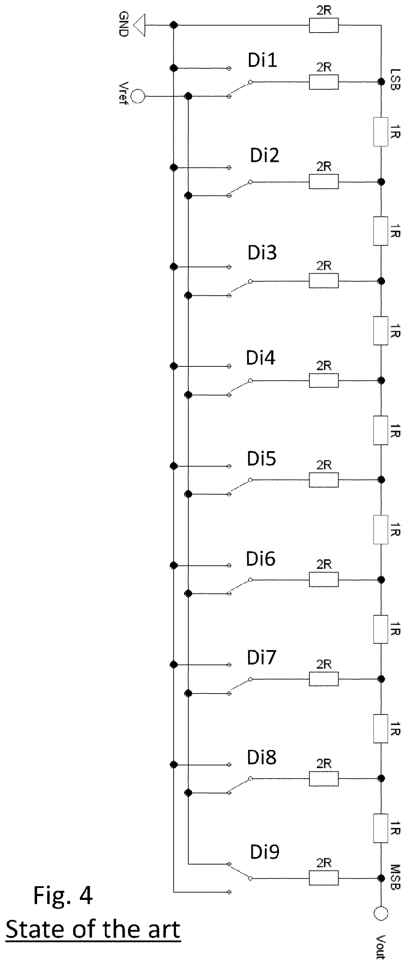

Figure 4 illustrates a 9-bit ladder DAC that gives 2^9 levels = 512 levels.

In the example the 9-bit "bit pattern" is show at "half of one bit" below midpoint or zero-crossing, therefore the output **Vout** is approximately **Vref**/2. The next step upwards is when bits 1 to 8 are set to the ground **GND** and bit 9 is set to **Vref.** Because all bits have changed there will be a center glitch or "zero-crossing" glitch.

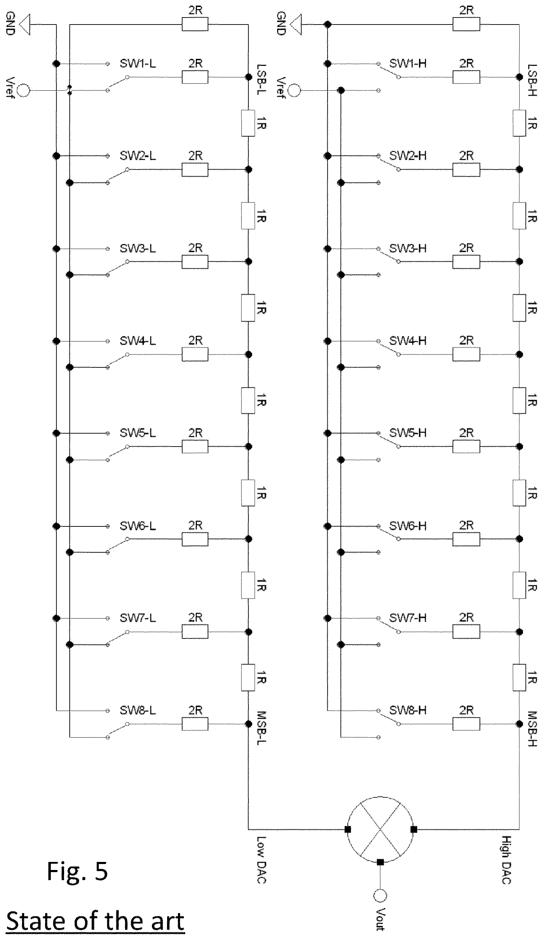

Figure 5 illustrates a 9-bit DAC sign magnitude (SM) DAC that gives 2x(2^8) levels = 512 levels.

The 9-bit SM DAC is made from two 8-bit DACs summed together at their outputs. The top 8-bit DAC is used for the top half of the output and the lower 8-bit DAC is used for the bottom half of the output. Therefore, in this configuration, the digital input is separated into two binary words including the digits **SW1-L-SW6-L** and **SW1-H-SW6-H.**

In this example, the bit patterns are shown at mid-point and therefore the output **Vout** is at **Vref**/2. Here, the top 8-bit DAC is set low; ready to be incremented to make the output **Vout** rise. The bottom 8-bit DAC is set high; ready to be decremented to make the output **Vout** fall.

The next step upwards is changing the LSB on the top 8-bit DAC to **Vref.** The next step downwards is changing the LSB on the bottom 8-bit DAC to ground **GND**.

This shows moving away from the zero-crossing point in either direction is only changing the LSB; therefore, there is no center glitch.

Apart from the glitch issue, R2R DACs also face monotonicity problems.

If a DAC is said to be monotonic then as the binary count increases so does the analogue output. If a DAC is not monotonic as the binary count increases the analogue output will decrease before increasing again.

Nonmonotonicity is caused by tolerance error in the DAC ladder. The tolerance required for the DAC ladder of an audio DAC is incredibly tight. If a 24-bit DAC ladder was made from resistors, then these would require a tolerance of 0.000006%. Readily available precision resistors are 0.01% and 0.001%. A 0.01% resistor will make a monotonic DAC with 13 bits accuracy and a 0.001% resistor will make a monotonic DAC with 16.5 bits accuracy.

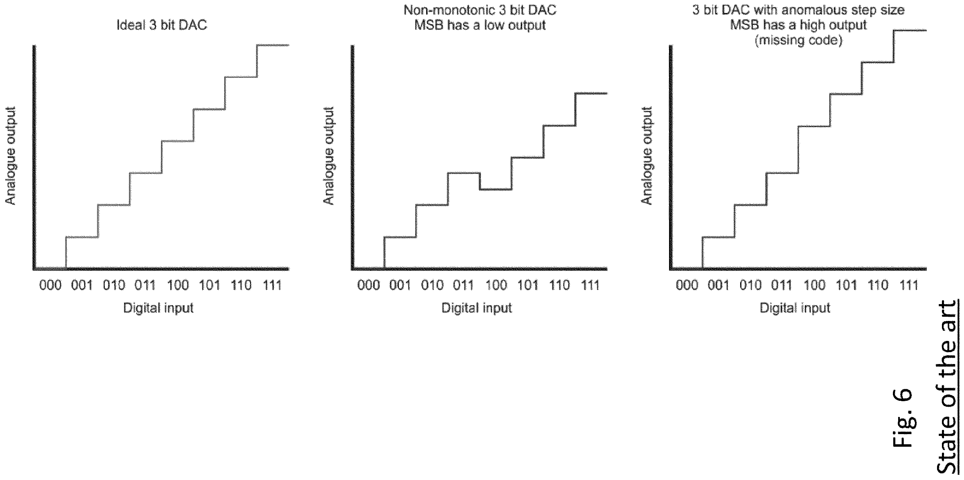

Figure 6 illustrates the effects of resistor error in DACs with an ideal 3-bit DAC, a non-monotonic 3-bit DAC where the MSB has a low output, and a 3-bit DAC with anomalous step size where the MSB has a high output.

Non-monotonicity can cause distortion in audio systems and in non-audio applications with feedback can cause stuck loops. Anomalous step sizes cause the same effect on sound quality but not such a problem for other applications with feedback. Interestingly most non-monotonic errors can be digitally removed at the expense of some resolution. Anomalous errors cannot be digitally removed as they represent a "missing code" or step.

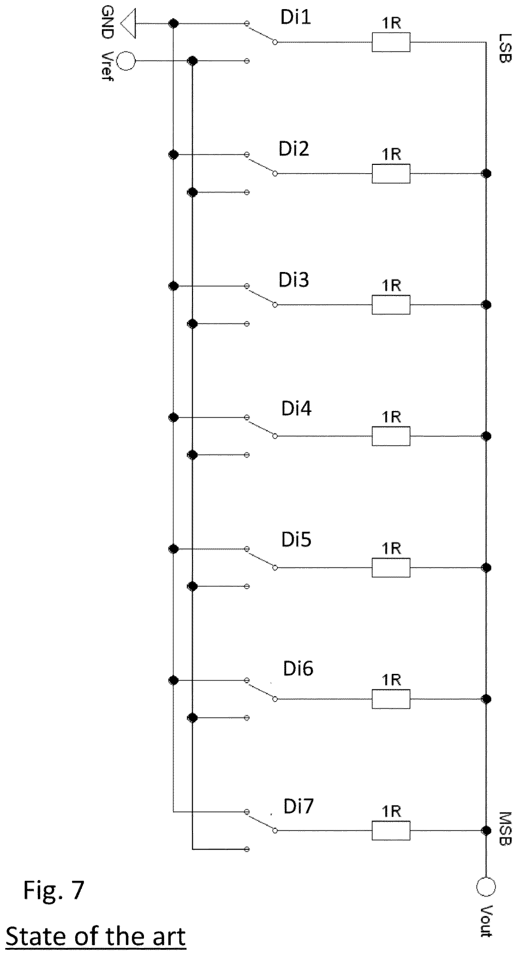

To overcome the issues of glitches and non-monotonicity, it's possible to come back to the old "thermometer" DAC. Figure 7 illustrates a thermometer DAC with 7 switches.

When all switches are connected to the ground **GND**, the output **Vout** is zero. To ramp the output **Vout,** one of the switches **Di1-Di7** can be connected to **Vref.** Then progressively switching one more switch **Di1-Di7** at a time to increase the output until all switches **Di1-Di7** are connected to **Vref** and the output **Vout** is at full.

The thermometer DAC has no glitch and has monotonicity in that as the digital word is increased the output is guaranteed to increase. Errors are small too and matching of resistors is not sensitive for a DAC. On paper it is near perfect.

In the example of figure 7 with 7 switches **SW1-SW7** and 7 resistors it gives a total possible 8 levels making it equivalent to a 3-bit resolution:
- Level 1 = 0 0 0 0 0 0 0 = minimum output;
- Level 2 = 0 0 0 0 0 0 1 = 1/7th output;
- Level 3 = 0 0 0 0 0 1 1 = 2/7th output;
- Level 4 = 0 0 0 0 1 1 1 = 3/7th output;
- Level 5 = 0 0 0 1 1 1 1 = 4/7th output;
- Level 6 = 0 0 1 1 1 1 1 = 5/7th output;
- Level 7 = 0 1 1 1 1 1 1 = 6/7th output; and
- Level 8 = 1 1 1 1 1 1 1 = max output.

The switches can be turned on in any order, i.e. to get 1/7th output **Vout** any one of the 7 switches **SW1-SW7** can be connected to **Vref**.

Its Achilles heel is its inefficiency of parts, to a point it can't be used for audio. To make a 24-bit audio thermometer DAC would require 16,777,216 resistors and switches. If each resistor was 1mm in size then the DAC channel would be 16km long.

Therefore, the technical problem is to build a digital to analog converter with low noise, low glitch energy, practical part count, scalable and capable of high-resolution audio such as 768 kHz 32-bit streams.

### DESCRIPTION

To solve this problem, the invention proposes a Nyquist DAC combining the thermometer and the R2R concepts.

Indeed, the invention proposes to use multiple thermometer clusters with different weights according to the different weights of the resistors of the R2R DACs.

In view of the invention, a "thermometer" cluster refers to a thermometer DAC as commented in view of Figure 7, where only one switch is moved in each incrementation or diminution of the logic level. Thus, for each thermometer cluster, only one switch is moved in each incrementation or diminution of the logic level of the cluster, but the switches can be turned on in any order.

The invention is a compromise between the advantages of thermometer DACs and R2R DACs and provides a structure which can fulfill the requirements of audio DACs, i.e. high-resolution audio such as 768 kHz 32-bit streams.

In other words, according to a first aspect, the invention relates to a digital to analog converter comprising :
- a digital input that can take multiple logical levels;
- a resistive network; and
- an analog output connected to said resistive network in order to produce an output voltage variable as a function of said logical levels of said digital input.

Such digital to analog converter is characterized in that it comprises :
- at least two thermometer clusters implemented in said resistive network with different weights on the analog output; for each thermometer cluster, only one switch is moved in each incrementation or diminution of the logic level of the thermometer cluster; and
- a logical command unit configured to convert said digital input into binary words in order to associate a dedicated binary word to each thermometer cluster.

Using multiple thermometer clusters with different weights, the invention permits to obtain a digital to analog converter with low noise, low glitch energy, practical part count, scalable and capable of high-resolution audio such as 768 kHz 32-bit streams.

Concerning the "low noise", it is debatable what level of signal to noise ratio (SNR) is required for high quality audio reproduction. Vinyl reply has a poor SNR compared to high resolution digital audio however the sound quality is superb.

Early CD player systems with a SNR greater than vinyl were considered too noisy and the noise was detrimental. It could be said that the type of noise has a bearing on the perception of quality. Constant white noise being acceptable and signal correlated noise being more noticeable or distracting.

Using multiple thermometer clusters with different weights, the invention has the lowest theoretical noise from a high-resolution DAC architecture due to its inherent low output impedance and Nyquist clock rate operation. Other techniques can also be employed to lower noise and some of these can also be applied to multiple DAC architectures such as using ultra quiet power supplies and screening.

The noise output from a circuit is made up from constituent parts such as of the effective series input impedance multiplied by the gain, the inherent output impedance, switching noise, quantization noise, PSU noise divided buy the PSU rejection ratio, susceptibility of self-generated or external pick up of electromagnetic interference and microphonic noise.

A Delta-Sigma DAC has an output impedance equal to the impedance of the switching element. If a Delta-Sigma DAC has a 10 kΩ resistor, an output signal level of 2 Vrms and measured over a 20 kHz bandwidth then then the maximum SNR is 120.8 dB. This assumes the output filter perfectly removes the oversampled clock and the digital over-sampling data has no math errors causing a noise floor modulation. Typically, Audio Delta-Sigma DACs have multiple phases. These additional phases work in parallel and reduce both static and dynamic noise.

An R2R DAC has an output impedance equal to 1R. Therefore, if the switching element is 10 kΩ and being the `2R' part of an R2R DAC the inherent output impedance is 5 kS2. With a 2 Vrms output and measured over a 20 kHz bandwidth this gives a SNR of 123.8 dB. This figure is the pure thermal noise contribution and is the same figure irrespective of bit depth. The data does not necessarily need to be over-sampled in an R2R DAC so the noise floor modulation due to math can be considered zero. The clock rate is at the Nyquist rate and is considerably lower than found in a Delta-Sigma DAC. This would typically be easier to filter due to less switching density.

A PCN DAC has an output impedance equal to the switching element resistance divided by the cluster number base size. Therefore, if the switching element is 10 kS2 then the output impedance of a septendecimal PCN DAC is 10 kS2/17= 588.3 Ω.

With a 2 Vrms output and measured over a 20 kHz bandwidth this gives a SNR of 133.1 dB. As per the R2R DAC this is the thermal noise contribution again no over-sampling is needed so no noise contribution and the figure does not change with bit depth.

PSU induced noise is similar for all types of DAC architectures. Methods to reduce PSU noise could be applied to all DACs. Math errors in Delta-Sigma over-sampling filters will generally be higher than that off Nyquist DACs that do not theoretically requires over-sampling.

Quantization noise can also be considered similar for all DAC architectures of equivalent bit depth and is not considered here.

If DAC was used to make an ultra-low noise DC reference, then the Delta-Sigma DAC would be running constantly generating switching noise. If an R2R DAC were to be used the clock could be stopped and noise is purely thermal. If a DAC according to the invention was used again the clock can be stopped and the noise would be thermal but lower due to the wide cluster width.

Concerning the glitches, R2R DACs inherently have a center glitch. For audio purpose, quiet music will be crossing the center and making many audible glitches. As musical notes disappear into silence the center point of the DAC will be crossed hundreds or thousands of times a second. These glitches can be louder than the audio. Thus, the center glitch, also called zero-crossing glitch, is the most detrimental glitch for audio purpose.

To overcome this center glitch, the logical command unit can be configured to apply an off-set to said digital input. The off-set pushes the audio zero cross away from the most significant cluster glitch and when the audio fades into silence the center line is not crossed.

Because the digital signal has had an off-set added it will "clip", i.e. cross the center of the scale, earlier in one direction and clip later in the other direction. Asymmetric clipping is not good for audio. Asymmetric clipping produces a DC off-set. Therefore, if a positive off-set is added then the logical command unit will artificially clip the negative earlier. The result is the positive and negative half cycles will now clip symmetrically. The disadvantage is a small amount of resolution is lost. The advantage of is that the size of the thermometer clusters could be multiple of two and the binary to binary words conversion is simpler. The easier way the remove the center glitch is obtained by moving away the size of the most significant cluster from binary (base 2). According to this embodiment, the cluster who has the greater impact on the output voltage, called the most significant cluster (MSC), corresponds to an odd cluster, i.e. a cluster with an odd number of logical levels.

The most significant cluster can be configured to use multiple high-order odd number systems such as enneaquadragesimal (base 49), tritrigesimal (base 33), septendecimal (base 17), nonary (base 9), ternary (base 3). The result is an elimination of the center glitch. This is because the DAC counts in either direction from the zero-cross point using the least significant cluster. In contrast, the R2R will traverse the zero-crossing point changing all bits including the MSB.

This embodiment not only eliminates the zero-crossing glitch using an odd cluster to form the most significant cluster but also dramatically attenuates all other glitches compared to R2R DACs including sign-magnitude R2R DACs.

The cluster bit width can be increased to improve performance. The wider the cluster the greater the reduction in glitch size and the greater the monotonicity for a given tolerance of resistor. The wider the clusters the more parts are needed for a given bit depth. Thus, it is desirable to have wide clusters and the decision on where to stop is keeping the DAC a practical size and cost.

The width of the clusters from the least significant to the most significant do not need to be the same size. In a preference embodiment, the cluster who has the greater impact on the output voltage, called the most significant cluster (MSC), possess a greater number of logical levels than the cluster who has the lesser impact on the output voltage, called the least significant cluster (LSC).

Thus, a single DAC can contain multiple cluster widths. For example, the least significant cluster that is for all intents and purposes in the noise floor do not need the same linearity as the more significant cluster. This least significant cluster could be ternary (base 3) and the most significant cluster could be tritrigesimal (base 33). The intermediate cluster widths can grow progressively from say ternary to quinary to nonary to septendecimal to tritrigesimal etc.

Digital electronics is traditionally in binary. Within the binary system bits, nibbles and bytes are used. Chipsets such as shift registers tend to reflect these sizes.

For example, an 8-bit or one-byte shift registers is a very common building block. A shift register is a key building block in all DACs from R2R to delta-sigma including DACs according to the invention. Engineering multiple thermometer cluster sizes based on available logic chips is also desirable for practicality. A single 8-bit shift register can be used to make four ternary clusters, 2 quinary clusters or one nonary cluster; two can be used to make a single septendecimal cluster etc.

A 24-bit sign-magnitude R2R DAC uses two 23-bit DACs, each 23-bit DAC uses 23 gates and 46 resistors, therefore on 24-bit sign-magnitude DAC integrates 46 gates and 92 resistors per channel.

To implement a 24-bit DAC with the invention, the following implementations are possible:
- 8 nonary clusters (base 9), using 64 gates and 72 resistors to obtain a 25.36-bit DAC;
- a septendecimal more significant cluster (base 17), 5 nonary clusters (base 9) and 2 quinary least significant clusters (base 5), using 64 gates and 72 resistors to obtain a 24.58-bit DAC;
- two septendecimal more significant clusters (base 17), 2 nonary clusters (base 9), 2 quinary 5 clusters (base 5) and 4 ternary least significant clusters (base 3), using 64 gates and 74 resistors to obtain a 25.5-bit DAC;
- two septendecimal more significant clusters (base 17), 3 nonary clusters (base 9) and 4 ternary least significant clusters (base 3), using 64 gates and 72 resistors to obtain a 24-bit DAC;
- a tritrigesimal more significant cluster (base 33), a pentavigesimal cluster (base 25), two septendecimal clusters (base 17) and 2 nonary least significant clusters (base 9), using 104 gates and 110 resistors to obtain a 24.2-bit DAC; and
- a nonaquadragesimal more significant cluster (base 49), a unquadragesimal cluster (base 41), a tritrigesimal cluster (base 33), a pentavigesimal cluster (base 25) and 2 nonary least significant clusters (base 9), using 160 gates and 166 resistors to obtain a 27-bit DAC.

The top four examples above all use less of the expensive tight tolerance resistors than a 24-bit sign-magnitude R2R DAC. Therefore, the invention can provide more efficient architecture than a sign-magnitude R2R DAC.

Concerning the different weights of the clusters on the output, multiple implementations are also possible.

According to an embodiment, at least two thermometer clusters are implemented in series in said resistive network separated by connection resistors, each switch of said at least two thermometer clusters being associated to a parallel resistor having the same value in each at least two thermometer clusters.

This embodiment is based on the ladder architecture of the R2R DACs. However, where an R2R DAC has one bit per "rung" of the ladder this embodiment has multiple bits per rung of the ladder. The multiple bits per rung are called "clusters". The larger the cluster the more the performance increases until a practical limit is reached. The advantage of a ladder architecture is that the thermometer clusters are made from the same value resistors. The disadvantage is a small "CR" time constant from one cluster to another. The "long" resistors and stray capacitance form the CR. This CR time constant causes a timing error manifesting itself as a glitch when transitioning between clusters.

According to an embodiment, at least two thermometer clusters are implemented in series in said resistive network, each switch of said at least two thermometer clusters being associated to a parallel resistor having different values between different thermometer clusters. By using different resistor values between different clusters, this embodiment allows for the removal of the connection resistors in the ladder architecture of the R2R DACs. Thus, this embodiment reduces the number of components in the resistive network.

Moreover, in this embodiment, there is no capacitance resistance (CR) time constant between the clusters. Indeed, in a DAC, the cluster resistance together with the "stray capacitance" of the physical component forms a CR time constant. This CR delays a cluster with respect to another cluster and causes a glitch. By using a resistive network where two thermometer clusters are implemented in series and associated to a parallel resistor having different values, the clusters are delayed together and there is no capacitance resistance (CR) time constant between the two clusters.

According to another embodiment, at least two thermometer clusters are implemented in parallel in said resistive network by connection resistors, each switch of said at least two thermometer clusters being associated to a parallel resistor having the same value in each at least two thermometer clusters, the connection resistors having different values between the at least two thermometer clusters.

The advantage of using parallel connected clusters is that the CR time constant is the same between the thermometer clusters, which can help to reduce some glitches in the circuit.

According to another embodiment, at least two thermometer clusters are implemented in series or in parallel in said resistive network, each switch of said at least two thermometer clusters being associated to a dedicated voltage source having different values between the at least two thermometer clusters.

One advantage of using voltage weighting in said resistive network is that it allows all of the resistors to be of the same value. This can simplify the design and manufacturing process, as only a single resistor value is needed. Additionally, voltage weighting can be used to fine-tune the weighting of the circuit for calibration purposes, which can be useful for achieving precise performance.

However, one disadvantage of using voltage weighting is that it can result in voltages that become either unmanageably large or small. This can be a particular issue in cases where the voltage needs to be very large or very small, as it may be difficult to design and manufacture a circuit that can handle such extreme voltages.

To mitigate this issue, it may be necessary to use techniques such as voltage division or amplification to reduce the impact of large or small voltages on the circuit's performance. Alternatively, it may be possible to combine different circuit configuration or a different type of resistor network to achieve the desired performance without the need for large or small voltages.

Concerning the logical command unit, it can be implemented as a lookup table (LUT). A LUT is very fast and can be easily used for the logical command unit of the invention where multiple number base conversions can be used. With a LUT the input digital word is used as an address for a memory. Within that memory location, the new converted word is written. With a large bit depth, the size of the memory is not practical. The input to the lookup table would need to be 24 bits wide, addressing 16,777,214 locations each containing a word of 64 bits wide (24-bit input to an 8 cluster nonary DAC).

In the construction of the LUT, a method can be devised using an `if then else' structure. This method takes the input word and compares to a known value. If the input is higher than the output bit one is set. The value of the output bit is taken away from the input, then the same process is done for the successive bits. This algorithm is fast, space efficient, bit perfect and is number base agnostic.

As an alternative, said logical command unit comprises:
- a weight function unit configured to determine the number of resistors of each thermometer cluster that must be activated; and
- at least one shift register unit associated to each thermometer cluster and connected to the weight function unit, each shift register unit being configured to determine which resistor(s) of each thermometer cluster must be activated as a function of the number of resistors calculated by said weight function unit.

The weight function unit could be made with a field-programmable gate array (FPGA) for converting the digital input to the number bases correspond to the thermometer cluster sizes. In this embodiment, the FPGA feeds shift registers that drive the resistive elements. For instance, the shift registers require a clock signal to clock new data into the cluster.

If no bits change in a specific thermometer cluster, then there's no need to send a clock to the associated shift register unit.

This embodiment reduces system noise for improved sound quality. As just running a clock to the latches creates a small amount of noise on the output. Thus, if the music is quiet the MSC (most significant cluster) will not change. Not sending a clock to the MSC latch will help reduce noise on the resistor ladder.

According to an embodiment, said at least one shift register unit is configured to randomly define which resistor(s) of each thermometer cluster must be activated as a function of the number of resistors calculated by said weight function unit. This embodiment describes a dynamic element matching (DEM). DEM turns resistor mismatch distortion into noise, it does this by randomly using different resistors.

In a single cluster of resistors, it is desired that each resistor has the same contribution to the output voltage. This means that if only one resistor is turned on, it should not matter which resistor in the cluster is turned on. For example, a nonary cluster with the word "1000000" should produce the same output voltage as the words "00010000" and "00000001".

However, it is possible that one resistor in the cluster may have a large error, causing a tone or distortion in the output signal. To mitigate this issue, the activation of the resistors in the cluster can be randomized. This can help to randomize the tone, reducing any distortions that may be caused by a particular resistor with a large error. It is important to be careful when using this technique, as it can potentially cause idle tones due to the repetitive nature of pseudo-randomization.

In addition, said at least one shift register unit can be controlled by a field-programmable gate array configured to monitor the duration of use of each resistor from the associated thermometer cluster and to define which resistor(s) from each thermometer cluster must be activated as a function of the number of resistor(s) calculated by said weight function unit and by promoting the less used resistor(s).

Moreover, said logical command unit can comprise a power supply unit associated with each thermometer cluster, said power supply unit comprising at least one trim resistor calibrated to limit the non-monotonicity of the associated thermometer cluster.

In a system with multiple resistor clusters, it is important to consider the monotonicity and linearity of the system as a whole. Monotonicity refers to the property of a function or system to always increase or always decrease as the input increases. Linearity refers to the degree to which a system's output is proportional to its input.

One way to improve the monotonicity and linearity of the system is to use separate power supply units for each cluster. This allows for small voltage trimming to be applied to each cluster, which can affect its weighting and monotonicity. It is important to use highly accurate resistors, such as 0.1% resistors, to join the clusters in order to ensure proper alignment. The power supply units should also have a high level of accuracy, with a tolerance of at least +/-0.1%.

To further improve the performance of the system, it may be necessary to use trim resistors to fine-tune the output. These resistors can be adjusted during testing and are typically in the megohm range. Digital potentiometers, which allow for automated calibration, can be used as trim resistors. Trimming the power supply units can be a transparent method for calibrating the system, as it does not directly affect the performance of the DAC. This method can be used to calibrate both monotonic and non-monotonic errors. It is important to exercise extreme care when separating the power supply units for each cluster, as even small drifts of 1pmm can impact performance.

The shift register units of said logical command unit can also be calibrated by measuring each step and choosing the more appropriate step for each respective input code in order to limit the non-monotonicity of the associated thermometer cluster.

Instead of hardware calibration, digital calibration can be used to linearize a digital to analog converter of the invention by measuring each step and choosing the more appropriate step for each respective input code. This can be successful if the digital to analog converter to be calibrated has a higher bit depth than required.

For practicality reasons it is too time consuming to measure each step, a 24-bit converter has 16,777,216 levels. If each measurement took 100ms, the whole measurement would take 2.77 weeks; 2x this for stereo. If the measurement settling time was reduced to 10ms the time would take nearly 2 days. The calibration lookup table would be over 50MB. The lookup table could be reduced in size by assuming the error from the input word would be small, therefore a deviation from the input word could be stored instead of the full 24-bit value.

A further simplification can be made by only measuring the output voltage contribution associated with each element of the digital to analog converter. For example, an eight cluster nonary digital to analog converter with 64 switched elements could be measured in 6.4 seconds assuming a measurement settling time of 100ms. The calibration can be applied by either calculating in real time or creating an offset lookup table. An offset lookup table requires less real time processing at the expense of memory.

The invention also concerns an audio amplifier comprising a digital to analog converter above described.

### BRIEF DESCRIPTION OF THE DRAWINGS

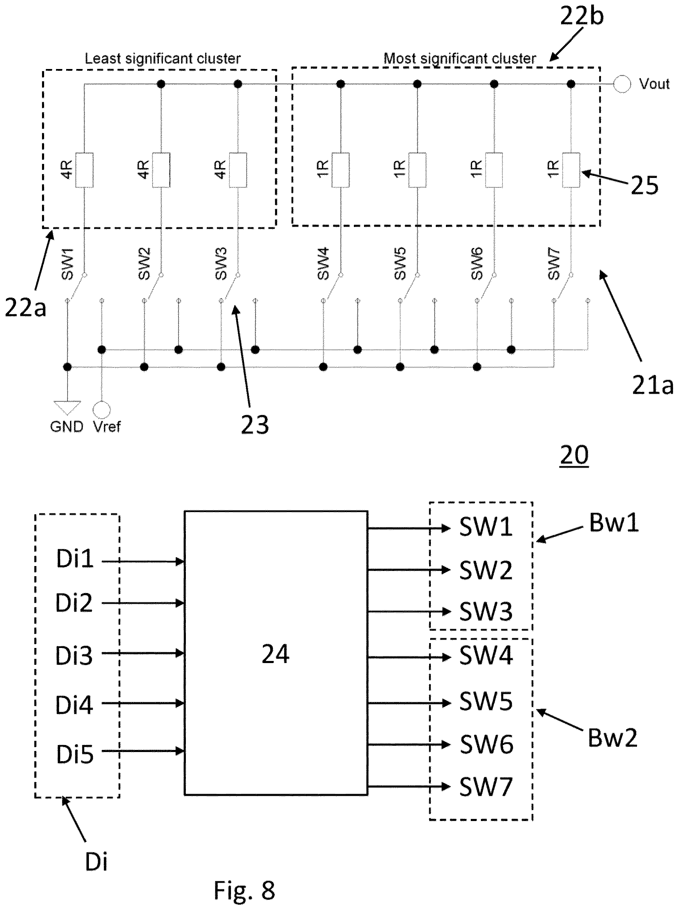

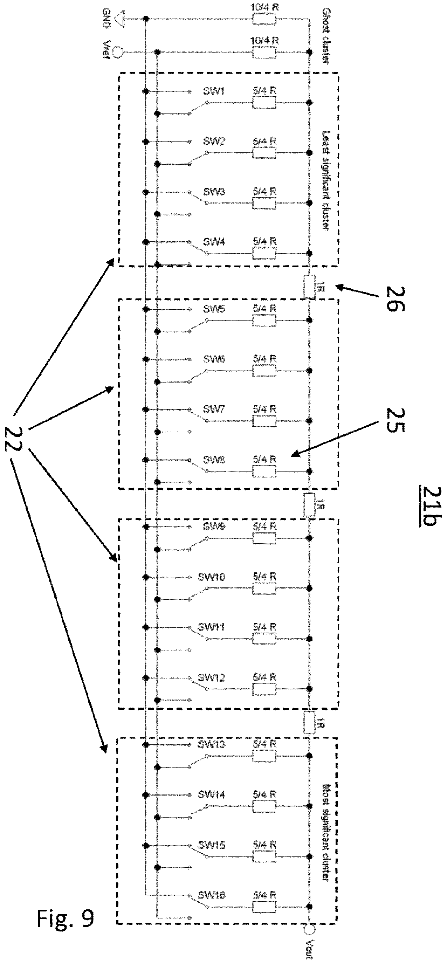

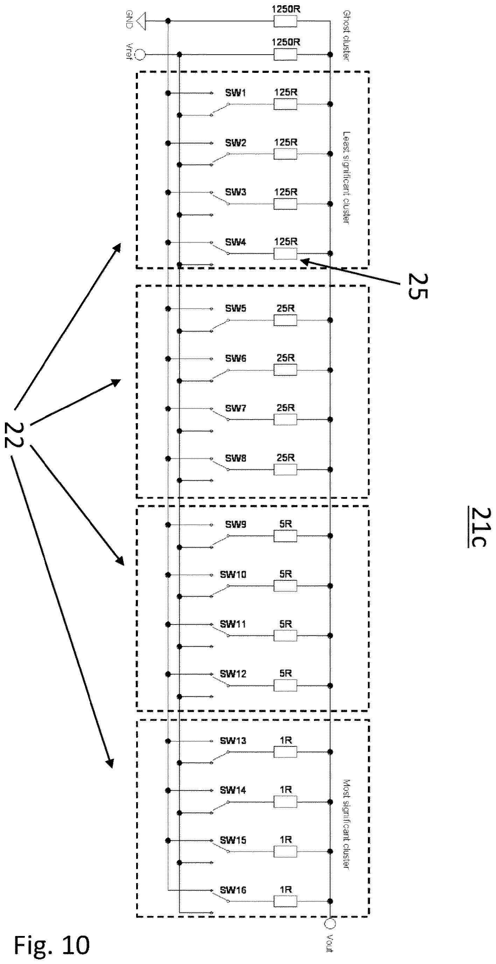

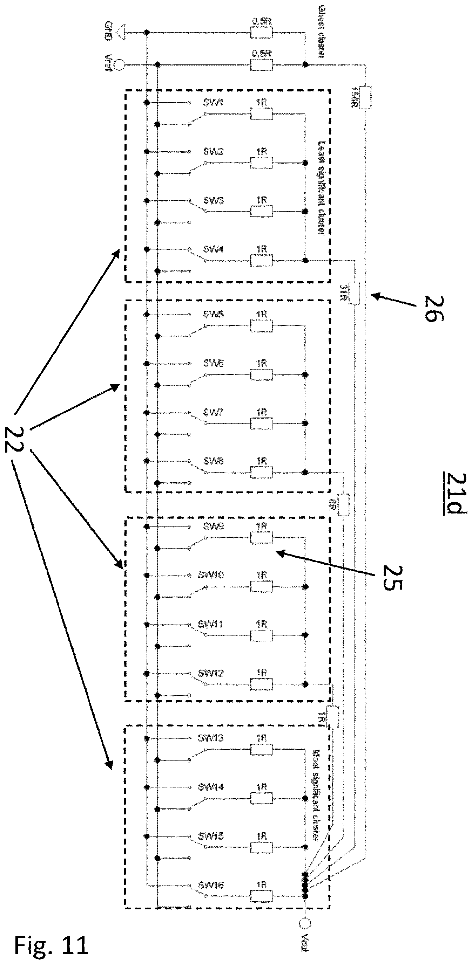

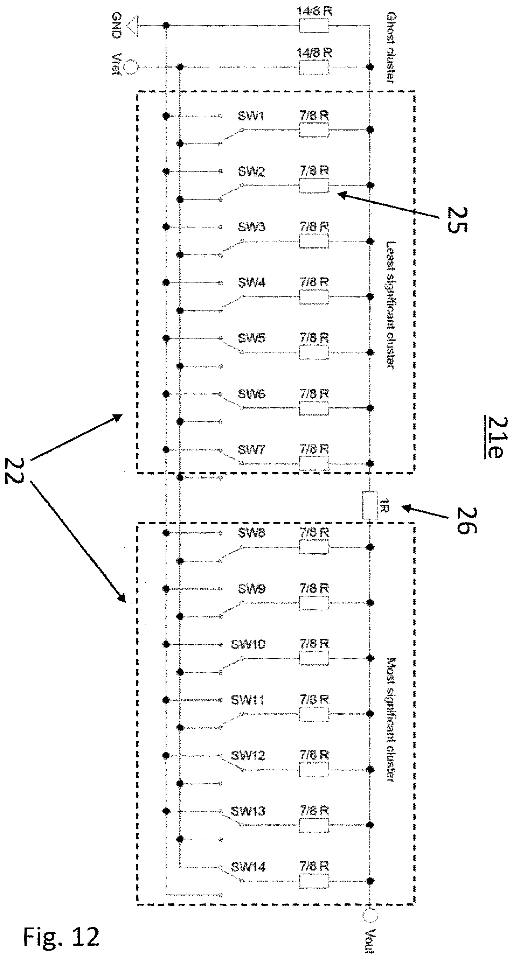

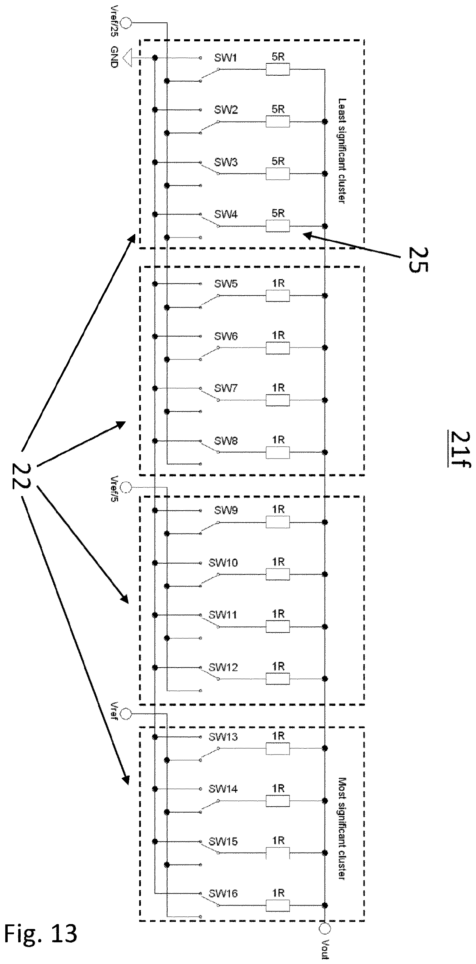

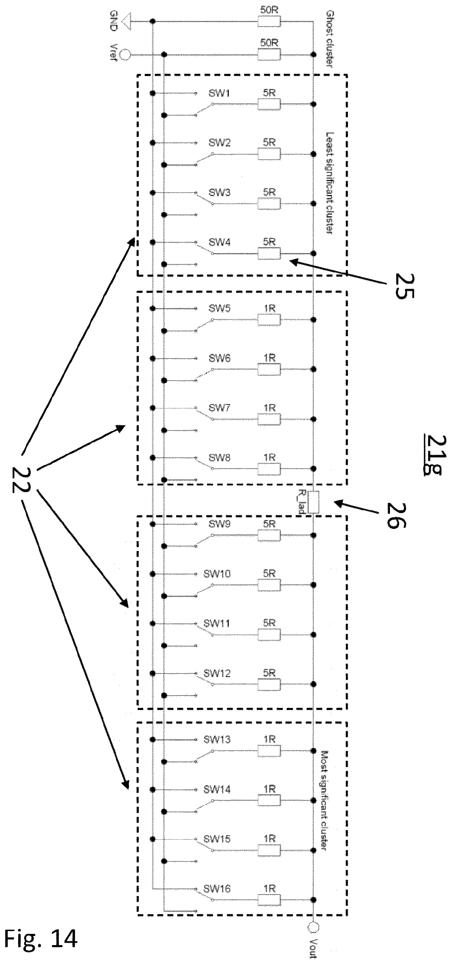

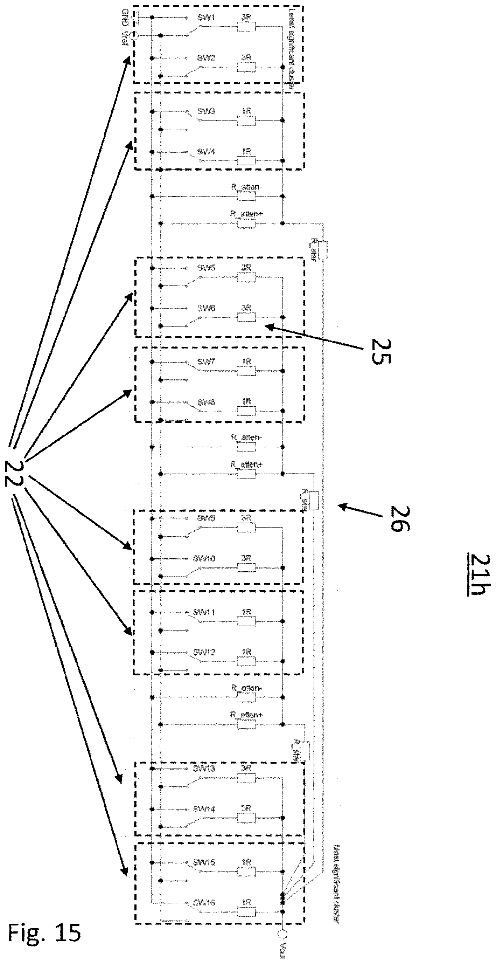

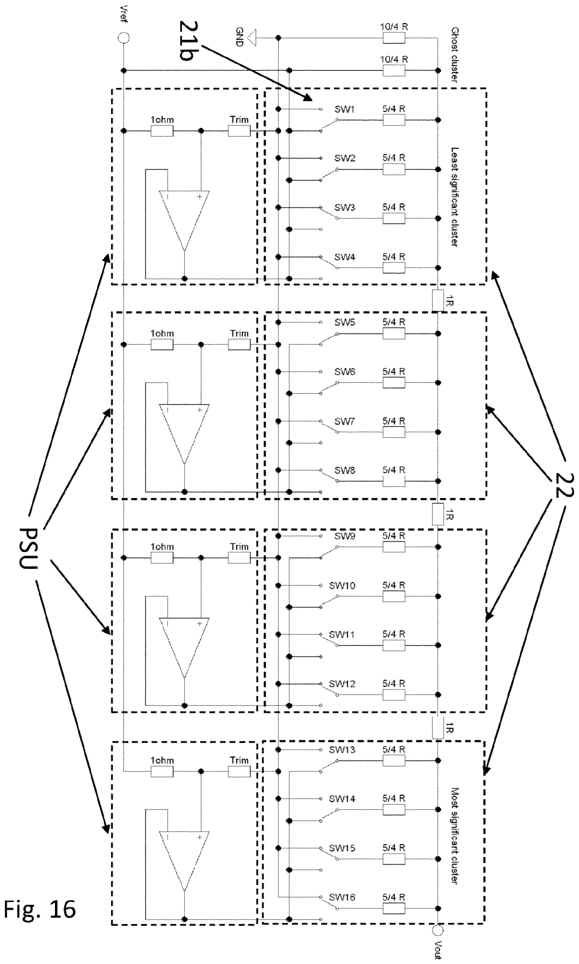

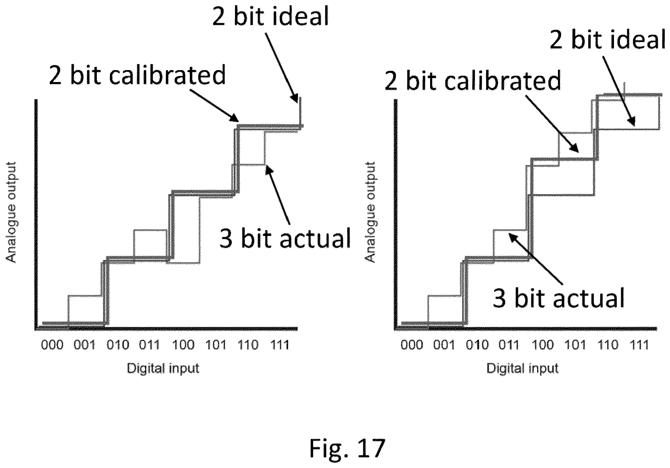

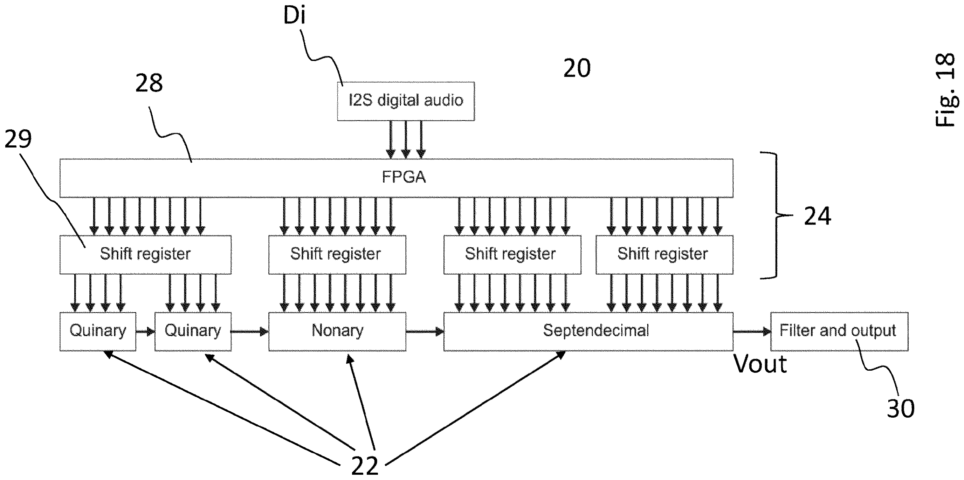

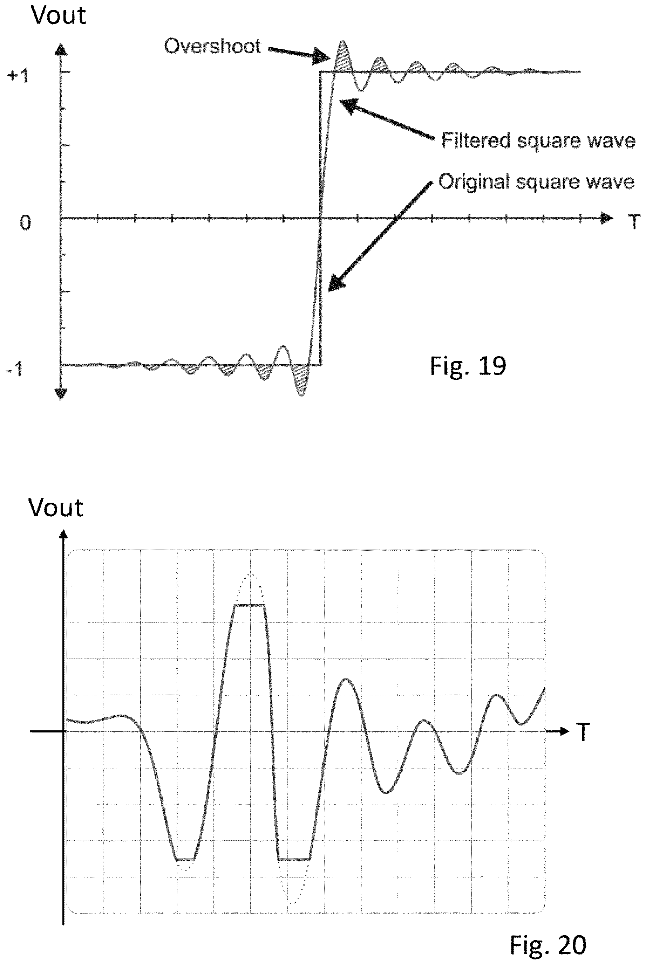

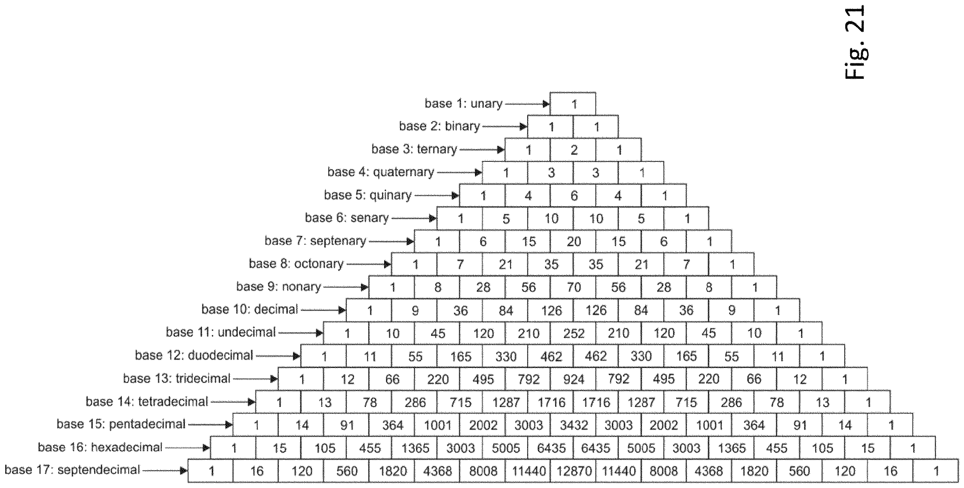

The invention will be well understood on reading of the following description, the details of which are given as an example only, and developed in relation with the appended drawings, where identical references relate to identical elements:
▪ Figure 1 illustrates the timing diagrams for the input and output of a Delta Sigma DAC of the state of the art;
▪ Figure 2 illustrates a schematic representation of the electronic circuit of a 3-bit R2R DAC of the state of the art;
▪ Figure 3 illustrates the timing diagrams of the 3-bit R2R DAC of Figure 2;
▪ Figure 4 illustrates a schematic representation of the electronic circuit of a 9-bit ladder DAC of the state of the art;
▪ Figure 5 illustrates a schematic representation of the electronic circuit of a 9-bit DAC sign magnitude of the state of the art;
▪ Figure 6 illustrates the evolution of the analog output in function of digital input for an ideal 3-bit DAC, a non-monotonic 3-bit DAC where the MSB has a low output, and a 3-bit DAC with anomalous step size where the MSB has a high output;
▪ Figure 7 illustrates a schematic representation of the electronic circuit of a thermometer DAC of the state of the art;
▪ Figure 8 illustrates a schematic representation of a DAC according to a first embodiment of the invention;
▪ Figure 9 illustrates a schematic representation of a resistive network of a DAC according to a second embodiment of the invention;
▪ Figure 10 illustrates a schematic representation of a resistive network of a DAC according to a third embodiment of the invention;
▪ Figure 11 illustrates a schematic representation of a resistive network of a DAC according to a fourth embodiment of the invention;
▪ Figure 12 illustrates a schematic representation of a resistive network of a DAC according to a fifth embodiment of the invention;
▪ Figure 13 illustrates a schematic representation of a resistive network of a DAC according to a sixth embodiment of the invention;
▪ Figure 14 illustrates a schematic representation of a resistive network of a DAC according to a seventh embodiment of the invention;
▪ Figure 15 illustrates a schematic representation of a resistive network of a DAC according to an eighth embodiment of the invention;
▪ Figure 16 illustrates a schematic representation of a resistive network of a DAC according to a ninth embodiment of the invention;
▪ Figure 17 illustrates the evolution of the analog output in function of digital input for two different configurations of the invention to show non-monotonic errors that can be corrected and anomalous errors that cannot be corrected;
▪ Figure 18 illustrates a schematic representation of a DAC according to an embodiment of the logical command unit of the invention;
▪ Figure 19 illustrates a timing diagram of an analog output of the invention showing inherent clipped overshoot of a full amplitude square wave after digital filtering;
▪ Figure 20 illustrates a timing diagram of an analog output of the invention showing how clipped recordings can be reconstructed using interpolation and square headroom; and
▪ Figure 21 illustrates pascals triangle to show the number of dynamic element matching or redundant state dithering sequences available for a given cluster size.

### DETAILED DESCRIPTION

Figure 8 illustrates a Digital to Analog Converter (DAC) **20** that converts a digital input **Di** into an analog output **Vout.** According to the invention, the DAC **20** comprises a resistive network **21a** with at least two thermometer clusters **22**.

In the example of figure 8, only two thermometer clusters **22a** and **22b** are implemented. The first thermometer cluster **22a** comprises three parallel resistors **25** of the same value 4R while the second thermometer cluster **22b** comprises four parallel resistors **25** of the same value R. Each parallel resistor **25** is connected between the analog output **Vout** and a dedicated switch **23** and each switch **23** can be connected either to the ground **GND** or the voltage source **Vref**.

These switch **23** are commanded by two binary words **Bw1, Bw2** generated by a logical command unit **24**. The logical command unit **24** receives the bits **Di1-Di5** of the digital input **Di** and converts the logical levels of these bits **Di1-Di5** into binary words **Bw1, Bw2.** For example, the logical command unit **24** may be to a lookup table.

The binary words **Bw1, Bw2** are used to command the switches **23** of the resistive network **21a** and the bits **SW1-SW3** control the switches **23** of the thermometer cluster **22a**, while the bits **SW4-SW7** control the switches **23** of the thermometer cluster **22b**.

By connecting one or more parallel resistor **25** to the voltage source **Vref**, the binary words **Bw1, Bw2** control the analog output **Vout.**

In this simple example shown in Figure 8, the resistive network **21a** comprises 7 switches **23**. The value of the parallel resistors **25** in the second thermometer cluster **22b** is lower than the value of the parallel resistors **25** in the first thermometer cluster **22a,** resulting in a higher weight for the second thermometer cluster **22b** on the analog output **Vout.** Therefore, the following levels can be obtained:
- Level 1 = 0 0 0 0 (cluster **22b**) 0 0 0 (cluster **22a**);
- Level 2 = 0 0 0 0 001; any of the switches of the cluster **22a** is moved to 1;
- Level 3 = 0 0 0 0 0 1 1 ; a second switch of the cluster **22a** is moved to 1;
- Level 4 = 0 0 0 0 1 1 1 ; the last switch of the cluster **22a** is moved to 1;
- Level 5 = 0 0 0 1 0 0 0 ; any of the switches of the cluster **22b** is moved to 1 and all switches of the cluster **22a** are moved to 0, occurring a 4-bit glitch;
- Level 6 = 0 0 0 1 001; any of the switches of the cluster **22a** is moved to 1;
- Level 7 = 0 0 0 1 0 1 1 ; a second switch of the cluster **22a** is moved to 1;
- Level 8 = 0 0 0 1 1 1 1 ; the last switch of the cluster **22a** is moved to 1;
- Level 9 = 0 0 1 1 0 0 0 ; another switch of the cluster **22b** is moved to 1 and all switches of the cluster **22a** are moved to 0, occurring a 4-bit glitch;
- Level 10 = 0 0 1 1 001; any of the switches of the cluster **22a** is moved to 1;
- Level 11 = 0 0 1 1 0 1 1 ; a second switch of the cluster **22a** is moved to 1;
- Level 12 = 0 0 1 1 1 1 1 ; the last switch of the cluster **22a** is moved to 1;
- Level 13 = 0 1 1 1 0 0 0 ; another switch of the cluster **22b** is moved to 1 and all switches of the cluster **22a** are moved to 0, occurring a 4-bit glitch;
- Level 14 = 0 1 1 1 001; any of the switches of the cluster **22a** is moved to 1;
- Level 15 = 0 1 1 1 0 1 1 ; a second switch of the cluster **22a** is moved to 1;
- Level 16 = 0 1 1 1 1 1 1 ; the last switch of the cluster **22a** is moved to 1;
- Level 17 = 1 1 1 1 0 0 0 ; the last switch of the cluster **22b** is moved to 1 and all switches of the cluster **22a** are moved to 0, occurring a 4-bit glitch;
- Level 18 = 1 1 1 1 001; any of the switches of the cluster **22a** is moved to 1;
- Level 19 = 1 1 1 1 0 1 1 ; a second switch of the cluster **22a** is moved to 1; and
- Level 20 = 1 1 1 1 1 1 1 ; the last switch of the cluster **22a** is moved to 1;

This simple example shows how the invention improves the number of levels that can reach a Nyquist DAC using multiple thermometer clusters **22a-22b** with different weights. Indeed, when a thermometer DAC using 7 switches can take only 8 levels, a multiple thermometer clusters using 7 switches divided in two clusters **22a-22b** can take 20 levels, i.e. less parts are required for the same level.

Compared to a thermometer DAC, the transition between clusters makes glitches. However, the glitches of the invention are way lower than the glitches of a R2R DAC. Indeed, in a R2R DAC of 7 switches, the bigger glitch can occur during the transition between the number 0111111 and the number 1000000. In this transition, all the switches are commuted, and a 7-bit glitch can occur. In the example of the invention, only a 4-bit glitch can be generated. Thus, the invention presents a low glitch energy compared to R2R DACs. Moreover, the DAC of the invention comes under the umbrella of the Nyquist group of DACs as it runs or can run at the sampling rate, limiting the noise and the clock jitter dependency.

With this concept of multiple thermometer clusters, many different implementations can be made. According to Figure 9, the resistive network **21b** can be implemented with 4 quinary thermometer clusters **22**, each consisting of 4 parallel resistors **25** with a value of 5/4R. These thermometer clusters **22** are connected in series, separated by connection resistors **26** with a value of R. A ghost cluster can also be present at the end of the line connected to the analog output **Vout.** This ghost cluster contains a resistance of the value 14/4R connected to the ground **GND** and a resistance of the value 14/4R connected to the voltage source **Vref**. This ghost cluster is used to form a voltage divider with the resistances of the values R and 5/4R, in order to set the analog output **Vout.**

In the embodiment shown in Figure 10, the ghost cluster of the resistive network **21c** is connected to 4 quinary thermometer clusters **22** without connection resistors **26**. In this embodiment, the thermometer clusters **22** contain parallel resistors **25** with different values, R, 5R, 25R, and 125R, between thermometer clusters **22**. In this embodiment, the resistances of the ghost cluster are adjusted to the value of the least significant cluster, i.e., the thermometer cluster **22** with the highest value of resistance 125R.

In the embodiment shown in Figure 11, the 4 quinary thermometer clusters **22** of the resistive network **21d** contain parallel resistors **25** with the same value R, but the thermometer clusters **22** are connected in parallel to the analog output **Vout.** The weight of the different cluster **22** is adjusted by connection resistors **26** of different values 1R, 6R, 31R and 156R. In this embodiment, the resistances of the ghost cluster are adjusted to a value 0.5R.

In figure 12, a resistive network **21e** composed of two thermometer clusters **22**, arranged in an even ordered octonary DAC, is represented. Each thermometer clusters **22** contains **7** parallel resistors **25** of the same value, 7/8R, and the two thermometer clusters **22** are connected in series with a connection resistor **26** of the value R. In this embodiment, the resistances of the ghost cluster are adjusted to a value 14/8 R.To overcome the inherent center glitch found in even-ordered clusters, a numeric off-set is added to the digital input **Di** by the logical command unit **24**. The off-set pushes the audio zero cross away from the most significant cluster glitch.

Without the off-set applied by the logical command unit **24**, the center glitch can be removed by using an odd thermometer cluster, i.e. a thermometer cluster with an odd number of logical levels, to form the most significant cluster. Using this technique, many glitches can be removed by using all the thermometer cluster **22** as odd clusters, as disclosed in figures 9 to 11. Moreover, the most significant cluster **22** can possess a greater number of logical levels than the least significant cluster **22**.

In the embodiment shown in Figure 13, three of the four quinary thermometer clusters **22** of the resistive network **21f** contain parallel resistors **25** with the same value R and the thermometer clusters **22** are connected in series to the analog output **Vout** without connection resistor **26**. The weight of the different cluster **22** is adjusted by the voltage source **Vref** of each thermometer clusters **22**. For the two least significant clusters **22**, the values of the parallel resistors **25** are R and 5R, and the voltage source is Vref/25. For the two most significant clusters **22**, the values of the parallel resistors **25** are R and the voltage sources are Vref/5 and Vref.

The invention can be made from any combination of the above-described embodiments. The individual properties of the embodiments can be exploited to maximize the DAC performance. Using combinations of cluster arrangements (segmentation) the glitches due to stray capacitance can be dramatically reduced and in some specific case theoretically eliminated.

In the embodiment shown in Figure 14, a quinary thermometer clusters **22** of the resistive network **21g** comprises two least significant clusters **22** connected with two most significant clusters **22** by a connection resistor **26**. For the two least significant clusters **22** and for the two most significant clusters **22**, the values of the parallel resistors **25** are R and 5R.

The value of the connection resistor **26** is R_lad, for instance R. In this embodiment, the resistances of the ghost cluster are adjusted to a value 50 R.

In Figure 15, a resistive network **21h** composed of 8-cluster ternary thermometer clusters **22** is represented. For each group of two clusters **22**, the values of the parallel resistors **25** are R and 3R. The three groups of two clusters **22** that have the least impact on the analog output **Vout** are connected in parallel through a connection resistor **26** of the value R_star. Moreover, a ghost cluster is implemented in each of the three groups of two clusters **22** that have the least impact on the analog output **Vout.** These ghost clusters have two resistors of the value R_atten- and R_atten+.

In summary, many different resistive network **21a-21h** can be created to form a DAC **20** with at least two thermometer clusters **22** with different weights on the analog output **Vout.** To control these thermometer clusters **22**, the logical command unit **24** is configured to convert the digital input **Di** into binary words **Bw1, Bw2**. This conversion can be made using a lookup table. Alternatively, the logical command unit **24** can be configured to create the binary words **Bw1, Bw2** in order to improve the DAC's performance.

Indeed, for a Nyquist DAC to have near perfect linearity its component parts require an almost unachievable accuracy. Without accuracy the DAC will product both harmonic and anharmonic distortions not consonant with musical reproduction. A 24 bit DAC typically requires a resistor tolerance of 0.000006% where the best parts available are about 0.001%. During the realization, to limit the distortions due to resistor tolerance, the resistors can be chosen using known techniques as laser trimming or binning. With the invention, the logical command unit **24** can also be configured to activate the resistors in each cluster in order to limit the distortions. Indeed, when a resistor must be activated in a cluster, it does not matter which resistor is activated and the logical command unit **24** can be configured to activate in priority the resistors having the better tolerance or measured value.

To do so, the logical command unit **24** can comprise a weight function unit **28** to determine the number of resistors of each thermometer cluster **22** that must be activated. Based on the number of resistors to activate, at least one shift register unit **29** can be associated to each thermometer cluster to determine which resistor(s) of each thermometer cluster **22** must be activated as a function of the number of resistors calculated by said weight function unit **28**. Moreover, dynamic element matching (DEM) can be also implemented in the logical command unit **24**.

DEM turns resistor mismatch distortion into noise, it does this by randomly using different resistors. Each resistor in a single cluster **22** should have the same contribution to output voltage **Vout.** i.e., if only one resistor is tuned on it does not matter which in the cluster is on; a nonary cluster word of 1000000 = 00010000 = 00000001 etc. However, one resistor may have a large error and this error can manifest itself as a tone or distortion. If the `firing order' of the cluster is randomised then the tone is randomised, a randomise tone is noise. Thus, in this embodiment, the shift register unit **29** are configured to randomly define which resistor(s) of each thermometer cluster **22** must be activated as a function of the number of resistors calculated by said weight function unit **28**.

The shift register unit **29** can also controlled by a field-programmable gate array (FPGA) to monitor the duration of use of each resistor from the associated thermometer cluster **22** and to define which resistor(s) from each thermometer cluster **22** must be activated as a function of the number of resistor(s) calculated by said weight function unit **28** and by promoting the less used resistor(s).

In the invention, because the thermometer clusters **22** are separated, the calibration of the resistors can also be made by voltage trimming. In this embodiment, the logical command unit **24** comprises a power supply unit (PSU) associated with each thermometer cluster **22**, as illustrated in figure 16 with the resistive network **21b** of figure 9. In this embodiment, the voltage source **Vref** is transmitted to the clusters using an operational amplifierand a fixed small resistor, for instance with a resistor value of 1 ohm, and a Trim resistor in the megohm range. The trim resistor allows a small voltage trimming to each cluster and that, in turn, affects it's weighting and monotonicity. If 0.1% resistors are used to connect each cluster then a PSU with at least +/-0.1% will correctly align the clusters.

Instead of hardware calibration digital calibration can be used to linearize a DAC by measuring each step and choosing the more appropriate step for each respective input code. The calibration can be applied by either calculating in real time or creating an offset lookup table. An offset lookup table requires less real time processing at the expense of memory. Figure 17 shows two examples of calibrating a 3-bit DAC to create a linear 2-bit DAC. In the first example the 3-bit DAC was measured, and the output was found to be non-monotonic. The calibrated output was successful. In the second example the DAC was measured and found to have an anomalous code. It was not possible to calibrate the error. Moreover, algorithm can be used to detect errors. For instance, redundant state dithering (RSD) is an algorithm that decorrelates errors caused by part tolerance so that they manifest as noise.

A DAC according to the invention has many input words that theoretically produce the same output voltage. These input words essentially redundant in a perfect world. In a practical realization, these redundant states will be minutely different.

For example, an eight cluster nonary DAC has 9^8 or 43 million possible discrete output voltage levels. The DAC, being made from 64 elements, has a total of 2^64 or over 18 million, million, million (18.447×10^18) possible input combinations. Therefore, there are, on average, nearly 500,000 million ways to produce each of the 43 million levels. This is an average; the levels near the minimum and maximum will have very few redundant states, while values in the center region will have the most redundant states.

Due to the weighting of each cluster, the vast number of redundant states will not be effective in spreading errors. The most effective RSD occurs when the redundant states are randomized within each cluster.

Figure 21 illustrates a Pascal's triangle. The horizontal lines show the number of combinations of '1' s for a given size of cluster to appreciate this amount.

One way to improve the performance of a digital audio system is to use a known dedicated format such as I2S (Inter-IC Sound) for the digital input. I2S is a standard for transmitting digital audio between integrated circuits (ICs) within an audio product, and consists of three lines: serial data, sample-rate clock, and bit clock. While I2S allows for efficient communication between ICs, it can also generate electromagnetic interference (EMI) noise, which can negatively impact the sound quality of the audio signal. This is because the EMI noise is correlated with the audio signal and can be easily discerned by sensitive analogue circuits.

To mitigate this issue, modern programmable audio ICs can be used to scramble the I2S data as it leaves one IC and then decode it when being received by the next IC. This has the effect of decorrelating the noise, resulting in uncorrelated wide-band noise that is less discernible and less detrimental to audio quality. By implementing this technique, the audio quality of the system can be improved, while still maintaining the benefits of using a dedicated digital format like I2S.

DGC (Dynamic Glitch Correction) is another algorithm designed to reduce unnecessary conversion noise in a PCN (Pulse Code Modulation) DAC (Digital-to-Analog Converter). Unlike some other techniques, DGC does not affect the linearity or monotonicity of the DAC.

In a typical PCN DAC, the FPGA is used to convert standard I2S digital audio into the number bases corresponding to the cluster sizes in the DAC. The FPGA feeds shift registers that drive the resistive elements in the DAC. These shift registers require a clock signal to clock new data into the cluster.

DGC works by only sending a clock signal to a latch if a bit in a specific cluster has changed. This reduces system noise and improves sound quality, as running a clock to the latches generates a small amount of noise on the output. For example, if the music is quiet, the MSC (most significant cluster) will not change. By not sending a clock to the MSC latch, DGC can help reduce noise on the resistor ladder.

Overall, DGC is a useful tool for improving the audio quality of PCN DACs by minimizing unnecessary conversion noise.

A DAC that combines several solutions, as shown in Figure 18, can be used in a digital audio system. This DAC **20** uses a FPGA to form the weight function unit **28**, which is part of the logical command unit **24**, together with the DGC algorithm. The FPGA takes in digital input using the I2S standard. The output of the FPGA is connected to shift register units that control four thermometer clusters **22**: two quinary, one nonary, and one septendecimal cluster.

Additionally, this DAC architecture can implement a transition optimization clocking (TOC) technique to spread EMI (Electromagnetic Interference) noise when data is clocked from the FPGA to the shift registers. Typically, digital audio data is sent from the FPGA at the sample rate (e.g., 768kHz). With TOC, the audio data can be sent bit by bit over the full sample rate period, increasing the frequency of the noise but lowering it by the total cluster widths.

In the embodiment shown in Figure 18, TOC sends the 32-bit data one bit at a time in a pseudo-random order. This increases the data rate to 32 times the sample rate and the overall EMI noise by 32 times. By using TOC in combination with other solutions, such as DGC and the use of a dedicated digital format like I2S, the DAC can achieve improved audio quality and reduced EMI noise.

The elements **30** shown in Figure 18 can also be used to improve the audio quality by filtering the analog output **Vout.** Many DAC cluster variations have a fractionally greater bit depth than desired. For example, an eight cluster nonary DAC has 43 million levels, equivalent to 25.36 bits.

If the target is 24 bits, the additional 1.36 bits can be used for overshoot on filters or to add room for reconstruction of clipped source audio in cases where the original signal was too large to be accurately represented by the DAC.

Figure 19 shows a filtered square wave that inherently has overshoot. Some other DAC architectures will clip the overshoot, resulting in a loss of part of the signal as shown in the crosshatch area. Figure 20 shows a clipped audio waveform, with the dotted line indicating a DSP (Digital Signal Processor) interpolated reconstruction of the original signal. By using filtering elements and techniques like DSP interpolation, it is possible to improve the audio quality and reduce the impact of clipping and overshoot in the output signal.

In conclusion, the invention proposes a DAC **20** with a dedicated structure using multiple thermometer clusters **22** that is capable of achieving low-noise, low-glitch energy conversion with a practical part count and is scalable for high-resolution audio such as 768 kHz 32-bit streams. This makes the invention well-suited for use in digital audio systems, such as in an audio amplifier. The combination of multiple solutions, including the use of a dedicated digital format like I2S (Inter-IC Sound), DGC (Dynamic Glitch Correction), and filtering elements, allows the DAC to provide high-quality audio with minimal noise and distortion.

## Claims

1. Digital to analog converter (20) comprising :
- a digital input (Di) that can take multiple logical levels;
- a resistive network (21a-21h); and
- an analog output (Vout) connected to said resistive network (21a-21h) in order to produce an output voltage variable as a function of said logical levels of said digital input (Di);
***characterized in that*** said digital to analog converter (20) comprises :
- at least two thermometer clusters (22, 22a, 22b) implemented in said resistive network (21a-21h) with different weights on the analog output (Vout); for each thermometer cluster (22, 22a, 22b), only one switch (23) is moved in each incrementation or diminution of the logic level of the thermometer cluster (22, 22a, 22b); and
- a logical command unit (24) configured to convert said digital input (Di) into binary words (Bw1, Bw2) in order to associate a dedicated binary word (Bw1, Bw2) to each thermometer cluster (22, 22a, 22b).

2. Digital to analog converter according to claim 1, ***wherein*** the thermometer cluster (22, 22a, 22b) who has the greater impact on the output voltage (Vout), called the most significant cluster, corresponds to an odd cluster, i.e. a thermometer cluster with an odd number of logical levels.

3. Digital to analog converter according to claim 2, ***wherein*** all the thermometer cluster (22, 22a, 22b) correspond to odd clusters, i.e.

4. Digital to analog converter according to claim 1, ***wherein*** the logical command unit (24) is configured to apply an off-set to said digital input.

5. Digital to analog converter according to one of claims 1 to 4, ***wherein*** the thermometer cluster (22, 22a, 22b) who has the greater impact on the analog output (Vout), called the most significant cluster, possess a greater number of logical levels than the thermometer cluster (22, 22a, 22b) who has the lesser impact on the analog output (Vout), called the least significant cluster.

6. Digital to analog converter according to one of the claims 1 to 5, ***wherein*** at least two thermometer clusters (22, 22a, 22b) are implemented in series in said resistive network (21a-21h) separated by connection resistors (26), each switch (23) of said at least two thermometer clusters (22, 22a, 22b) being associated to a parallel resistor (25) having the same value in each at least two thermometer clusters (22, 22a, 22b).

7. Digital to analog converter according to one of the claims 1 to 6, ***wherein*** at least two thermometer clusters (22, 22a, 22b) are implemented in series in said resistive network (21a-21h), each switch (23) of said at least two thermometer clusters (22, 22a, 22b) being associated to a parallel resistor (25) having different values between different thermometer clusters (22, 22a, 22b).

8. Digital to analog converter according to one of the claims 1 to 7, ***wherein*** at least two thermometer clusters (22, 22a, 22b) are implemented in parallel in said resistive network (21a-21h) by connection resistors (26), each switch (23) of said at least two thermometer clusters (22, 22a, 22b) being associated to a parallel resistor (25) having the same value in each at least two thermometer clusters (22, 22a, 22b), the connection resistors (26) having different values between the at least two thermometer clusters (22, 22a, 22b).

9. Digital to analog converter according to one of the claims 1 to 8, ***wherein*** at least two thermometer clusters (22, 22a, 22b) are implemented in series or in parallel in said resistive network (21a-21h), each switch (23) of said at least two thermometer clusters (22, 22a, 22b) being associated to a dedicated voltage source (Vref, Vref/5, Vref/25) having different values between the at least two thermometer clusters (22, 22a, 22b).

10. Digital to analog converter according to one of claims 1 to 9, ***wherein*** said logical command unit (24) corresponds to a lookup table.

11. Digital to analog converter according to one of claims 1 to 10, ***wherein*** said logical command unit (24) comprises:
- a weight function unit (28) configured to determine the number of resistors of each thermometer cluster (22, 22a, 22b) that must be activated; and
- at least one shift register unit (29) associated to each thermometer cluster (22, 22a, 22b) and connected to the weight function unit (28), each shift register unit (29) being configured to determine which resistor(s) of each thermometer cluster (22, 22a, 22b) must be activated as a function of the number of resistors calculated by said weight function unit (28).

12. Digital to analog converter according to claim 11, ***wherein*** said at least one shift register unit (29) is configured to randomly define which resistor(s) of each thermometer cluster (22, 22a, 22b) must be activated as a function of the number of resistors calculated by said weight function unit (28).

13. Digital to analog converter according to claim 11 or 12, ***wherein*** said at least one shift register unit (29) is controlled by a field-programmable gate array configured to monitor the duration of use of each resistor from the associated thermometer cluster (22, 22a, 22b) and to define which resistor(s) from each thermometer cluster (22, 22a, 22b) must be activated as a function of the number of resistor(s) calculated by said weight function unit (28) and by promoting the less used resistor(s).

14. Digital to analog converter according to one of claims 11 to 13, ***wherein*** said logical command unit (24) comprises a power supply unit (PSU) associated with each thermometer cluster (22, 22a, 22b), said power supply unit (PSU) comprising at least one trim resistor (Trim) calibrated to limit the non-monotonicity of the associated thermometer cluster (22, 22a, 22b).

15. Digital to analog converter according to one of claims 11 to 14, ***wherein*** the shift register units (29) of said logical command unit (24) is calibrated by measuring each step and choosing the more appropriate step for each respective input code in order to limit the non-monotonicity of the associated thermometer cluster (22, 22a, 22b).

16. Audio amplifier comprising a digital to analog converter (20) according to any of claims 1 to 15.
